# EUROPÄISCHE PATENTANMELDUNG

(11) **EP 4 432 371 A1**
(43) Veröffentlichungstag der Anmeldung: **18.09.2024**
(21) Anmeldenummer: 23162557.5
(22) Anmeldetag: 17.03.2023
(51) Int. Cl.: H01L 31/044, H02S 40/34

(54) **PHOTOVOLTAIK-MODUL**

(71) Anmelder: AT Advanced Technologies GmbH, 86343 Königsbrunn (DE)
(72) Erfinder: Maier, Waldemar, 86343 Königsbrunn (DE); Maier, Viktor, 86343 Königsbrunn (DE); Dr. Hanifi, Hamed, 86343 Königsbrunn (DE)
(74) Vertreter: dompatent von Kreisler Selting Werner - Partnerschaft von Patent- und Rechtsanwälten mbB

(57) **Zusammenfassung**

Die Erfindung betrifft ein Photovoltaik-Modul (10), umfassend:
- einen Rahmen (12),
- mehrere innerhalb des Rahmens (12) aufgenommene Solar-Strings (14), wobei jeder Solar-String (14) mehrere Solarzellen (28) aufweist, die seriell miteinander verbunden sind, und die Solar-Strings (14) parallel miteinander verbunden sind; und
- mindestens zwei Überbrückungselemente (20), wobei die mindestens zwei Überbrückungselemente (20) in einem Randbereich (22) des Photovoltaik-Moduls (10) angeordnet sind, der parallel zu der Längsachse des Photovoltaik-Moduls (10) verläuft.

## Beschreibung

Die vorliegende Erfindung betrifft ein Photovoltaik-Modul zur Umwandlung von Solarenergie in elektrische Energie. Insbesondere betrifft die vorliegende Erfindung ein bifaziales Photovoltaik-Modul, das zwei aktive Seiten aufweist, die zur Erzeugung elektrischer Energie dienen.

Photovoltaik-Module (auch als PV-Module bezeichnet) sind im Allgemeinen bekannt und werden weltweit eingesetzt, um elektrische Energie zu erzeugen, und zwar ohne auf fossile Energieträger zugreifen zu müssen. PV-Module werden als monofaziale PV-Module mit einer aktiven Seite (auch als Vorderseite des PV-Moduls bezeichnet) oder als bifaziale PV-Module mit zwei aktiven Seiten (eine aktive Vorderseite und eine aktive Rückseite des PV-Moduls) ausgeführt.

Beispielsweise weist ein typisches bifaziales PV-Modul eine Glasplatte, Verkapselungsmaterial, eine Rückwand, Solarzellen, beschichteten Drähte, eine oder mehre Anschlussdosen und Kabel auf. Vollformatige Solarzellen (im Englischen auch als full-size solar cells bezeichnet) sind in Reihe geschaltet und am Ausgang befindet sich eine Anschlussdose mit drei Überbrückungsdioden (im Englischen auch als bypass diodes bezeichnet) und zwei Ausgangsklemmen. Die Anschlussdose wird normalerweise an der kurzen Ober- oder Unterseite des Moduls angebracht und führt zu einer teilweisen Abschattung der bifazialen Solarzellen. In halbformatigen PV-Modulen (auch als half-size solar cell PV module bezeichnet) sind die Solarzellen jeweils in der oberen und der unteren Hälfte des PV-Moduls in Reihe geschaltet. Dann werden die untere und obere Hälfte in der Mitte des PV-Moduls an der kurzen Seite des PV-Moduls parallel geschaltet.

Aufgrund des Verschaltungsdesigns können die Überbrückungs-Dioden nicht in einer einzigen Anschlussdose untergebracht werden und sind daher in drei kleinen Anschlussdosen in der Mitte des PV-Moduls verteilt. Die erste und die dritte Anschlussdose enthalten die Ausgangsklemmen und die Kabelanschlüsse. Sowohl bei Solarzellen im Vollformat- als auch bei Solarzellen im Halbformat-Design verursachen die aus den Anschlussdosen führenden Kabel zu einer Abschirmung bzw. Abschattung auf der Rückseite des PV-Moduls, die zu Fehlanpassung und Leistungsverlust führen. Je höher die Bifazialität und die Nennleistung der Solarzellen auf der Rückseite ist, desto mehr Leistung geht durch die Teil-Abschirmung verloren. Darüber hinaus ist im Falle vorhandener Defekte und Mikrorisse langfristig ein höheres Risiko von Hotspots in den abgeschirmten Bereichen zu erwarten.

Mit der vorliegenden Erfindung wird ein Photovoltaik-Modul (nachfolgend auch als PV-Modul bezeichnet) vorgestellt, das mit unterschiedlicher Ausrichtung betrieben werden kann und unterschiedliche Verschaltungen von Solarzellen aufweisen kann. In einigen Ausführungsformen der Erfindung können Anschlussdosen und Überbrückungselemente vorgesehen sein. Gemäß einigen Ausführungsformen der Erfindung können PV-Module mit Kabellängen ermöglicht werden, die im Vergleich zu den aus dem Stand der Technik bekannten PV-Modulen deutlich kürzer sind.

Das PV-Modul gemäß der vorliegenden Erfindung kann insbesondere bifazial ausgebildet sein, wobei Abschirmeffekte bzw. Abschattungseffekte, die durch die Anschlussdose und die Kabel induziert werden, signifikant reduziert werden. Dadurch wird die Energieausbeute, insbesondere auf der Rückseite des PV-Moduls verbessert.

Im Rahmen der vorliegenden Erfindung werden insbesondere zwei Ausführungsformen vorgestellt, wobei die Überbrückungselemente einerseits in das Laminat des PV-Moduls eingebettet werden können oder alternativ in verteilten Anschlussdosen angeordnet sind, die in einem Randbereich angeordnet sind, der entlang der längeren Seite des PV-Moduls verläuft. Ferner können die Kabelanschlüsse an den Ecken des PV-Moduls positioniert sein. Das PV-Modul gemäß der vorliegenden Erfindung erreicht eine besonders hohe Leistung, wenn es vertikal installiert wird. Es kann aber alternativ auch horizontal betrieben werden.

Bei klassischen PV-Modulen besteht ein häufig auftretendes Problem darin, dass Abschattungseffekte durch Anschlussdosen und Kabel des PV-Moduls entstehen, wodurch die Effizienz des PV-Moduls signifikant beeinträchtigt wird. Derartige Abschattungseffekte, die durch Komponenten des PV-Moduls selbst entstehen (im Gegensatz zu den nicht vermeidbaren Abschattungseffekten durch äußere Objekte), werden auch als Selbstabschattung oder Selbstabschirmung bezeichnet.

Aufgabe der vorliegenden Erfindung ist es daher, ein PV-Modul bereitzustellen, bei dem die Abschattungseffekte vermieden oder zumindest reduziert werden.

Zur Lösung der vorstehend genannten Aufgabe wird mit der vorliegenden Erfindung ein Photovoltaik-Modul vorgeschlagen, umfassend:
- einen Rahmen,
- mehrere innerhalb des Rahmens aufgenommene Solar-Strings, wobei jeder Solar-String mehrere Solarzellen aufweist, die seriell miteinander verbunden sind, und die Solar-Strings miteinander verbunden sind; und
- mindestens zwei Überbrückungselemente, wobei die mindestens zwei Überbrückungselemente in einem Randbereich des Photovoltaik-Moduls angeordnet sind, der parallel zu der Längsachse des Photovoltaik-Moduls verläuft.

Durch die Anordnung der Überbrückungselemente in dem Randbereich, der entlang der Längsachse des PV-Moduls verläuft, wird erreicht, dass die Abschirmeffekte im Vergleich zu den PV-Modulen gemäß dem Stand der Technik signifikant reduziert werden. Der Randbereich umfasst dabei insbesondere einen rechteckigen Bereich, der eine Längsseite aufweist, die mit einer der beiden Längskanten des (ebenfalls rechteckigen) PV-Moduls identisch ist und eine Querseite, die 15 %, bevorzugt 10 % und besonders bevorzugt 5 % der Querkante des PV-Moduls beträgt. Damit umfasst der Randbereich insgesamt 15 %, bevorzugt 10 % und besonders bevorzugt 5 % der gesamten Querschnittsfläche des PV-Moduls.

Die Solar-Strings des PV-Moduls sind bevorzugt in einer Ebene angeordnet. Die Überbrückungselemente sind bevorzugt mit jeweils einem Solar-String verbunden und dazu ausgelegt, einen Solar-String zu überbrücken, wenn dieser fehlerhaft arbeitet, und insbesondere wenn dieser abgeschattet ist.

Gemäß einer Ausführungsform des erfindungsgemäßen PV-Moduls kann vorgesehen sein, dass das Photovoltaik-Modul als bifaziales PV-Modul ausgebildet ist. Die Effizienzsteigerung durch die vorliegende Erfindung ist bei bifazialen PV-Modulen besonders stark, da Abschirmeffekte, welche die Rückseite des PV-Moduls betreffen, besonders reduziert werden.

Auch kann vorgesehen sein, dass mindestens ein Überbrückungselement als Überbrückungsdiode ausgestaltet ist. Andere Ausführungsformen von Überbrückungselementen können ebenfalls zum Einsatz kommen. Insbesondere kann jede weitere elektronische Schaltung als Überbrückungselement eingesetzt werden, die es erlaubt, einen alternativen Strompfad im Falle einer Fehlfunktion einer Solarzelle oder eines Solar-Strings bereitzustellen.

Ferner kann gemäß dem erfindungsgemäßen PV-Modul vorgesehen sein, dass die Überbrückungselemente zwischen dem Rahmen und den Solarzellen angeordnet sind. Dadurch wird eine besonders effiziente Vermeidung von Abschirmeffekten ermöglicht, da die Überbrückungselemente in einem Bereich angeordnet werden, der keinerlei Schatten verursachen kann. Dadurch kann die Effizienz des PV-Moduls weiter erhöht werden.

Darüber hinaus kann vorgesehen sein, dass die Überbrückungselemente in einem Laminat eingebettet sind. Dies bietet den zusätzlichen Vorteil, dass die Überbrückungselemente besonders stabil gehalten werden und dadurch verhindert werden kann, dass die Überbrückungselemente derart deplatziert werden, dass sie eine oder mehrere Solarzellen abschirmen können. Auch vereinfacht sich durch die Einbettung der Überbrückungselemente in dem Laminat die Montage des PV-Moduls, da die Überbrückungselemente nicht mehr verschraubt oder anderweitig befestigt werden müssen. Auch erübrigt sich durch dieses Design die Notwendigkeit von Anschlussboxen bzw. Anschlussdosen.

Alternativ kann vorgesehen sein, dass die Überbrückungselemente jeweils in einer Anschlussbox angeordnet sind. Diese Anschlussbox kann dann in dem vorstehend beschriebenen Randbereich des PV-Moduls angeordnet sein. Durch die Anordnung der Anschlussbox im Randbereich des PV-Moduls wird erreicht, dass die Abschirmeffekte, welche durch die Anschlussbox verursacht werden, im Vergleich zu der Anordnung in der Mitte des PV-Moduls gemäß dem Stand der Technik deutlich reduziert werden können.

Gemäß einigen bevorzugten Ausführungsformen des erfindungsgemäßen PV-Moduls kann insbesondere vorgesehen sein, dass die Anschlussbox eine flache Form aufweist. Die Dicke der Anschlussbox kann dabei insbesondere d_AB < 0,5 x I_AB betragen, wobei d_AB die Dicke der Anschlussbox und I_AB die Länge der Anschlussbox bezeichnet, und wobei bevorzugt d_AB < 0,2 x I_AB beträgt und besonders bevorzugt d_AB < 0,1 × I_AB beträgt. Durch die flache Ausgestaltung der Anschlussbox werden die Abschirmeffekte, die durch die Anschlussbox verursacht werden, weiter reduziert und folglich die Effizienz des PV-Moduls weiter erhöht.

Des Weiteren kann gemäß der vorliegenden Erfindung vorgesehen sein, dass die Solar-Strings eine Längsausrichtung aufweisen und diese Längsausrichtung orthogonal zu der Längsachse des Photovoltaik-Moduls verläuft.

Auch kann gemäß der vorliegenden Erfindung vorgesehen sein, dass
- mindestens zwei Solarzellen seriell zu einem Substring verschaltet sind;
- mindestens zwei Substrings parallel zueinander verschaltet sind;
- jeweils mindestens zwei parallele Substrings seriell zu einem Solar-String verschaltet sind; und
- jeweils ein Solar-String mit einem Überbrückungselement verbunden ist.

Schließlich können bei dem erfindungsgemäßen PV-Modul Kabelanschlüsse vorgesehen sein, die in einem Eckbereich des Photovoltaik-Moduls angeordnet sind. Durch die Anordnung der Kabelanschlüsse in einem Eckbereich des Photovoltaik-Moduls können Abschirmeffekte, die in der Praxis durch freie Kabel erzeugt werden, weiter reduziert werden. Der Eckbereich beschreibt dabei insbesondere einen quadratischen Bereich, der an einen der vier Eckpunkte des Photovoltaik-Moduls angrenzt und eine Seitenlänge a_EB aufweist, wobei bevorzugt a_EB < 0,2 x I_PV beträgt und a_EB die Seitenlänge des Eckbereichs sowie I_PV die Länge des Photovoltaik-Moduls bezeichnet, und wobei besonders bevorzugt a_EB < 0,1 × I_PV und insbesondere a_EB < 0,05 x I_PV beträgt.

Nachfolgend wird die vorliegende Erfindung anhand der Figuren näher erläutert. Dabei zeigen die Figuren Folgendes:
- Fig. 1: eine schematische Darstellung eines Photovoltaik-Moduls gemäß dem Stand der Technik,
- Fig. 2: eine schematische Darstellung eines ersten Ausführungsbeispiels der vorliegenden Erfindung,
- Fig. 3: eine schematische Darstellung eines zweiten Ausführungsbeispiels der vorliegenden Erfindung, und
- Fig. 4: eine schematische Darstellung eines dritten Ausführungsbeispiels der vorliegenden Erfindung.

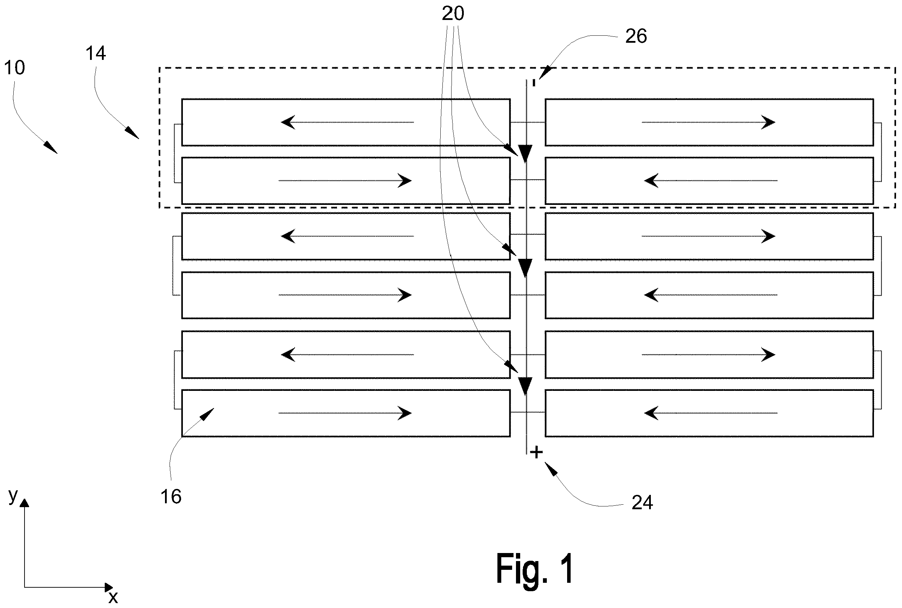

In der Fig. 1 ist ein Photovoltaik-Modul 10 gemäß dem Stand der Technik abgebildet. Das PV-Modul 10 weist einzelne Solar-Strings 14 auf, die mehrere Substrings 16 umfassen. Jedem der Solar-Strings 14 ist ein Überbrückungselement 20 zugeordnet, welches in der Fig. 1 als Überbrückungsdiode ausgestaltet ist. Die Überbrückungselemente sind bei dem gezeigten PV-Modul 10 mittig angeordnet. Dies hat allerdings den Nachteil, dass signifikante Abschirmeffekte durch die mittig angeordneten

Überbrückungselemente 20 entstehen (auch als Selbstabschirmung bezeichnet). Der Selbstabschirmungseffekt ist insbesondere bei bifazialen PV-Modulen von Nachteil. Aber auch bei monofazialen PV-Modulen kann der Selbstabschirmeffekt zu einer Verringerung der Gesamtleistung eines PV-Moduls beitragen. Das in der Fig. 1 gezeigte PV-Modul 10 weist zudem einen positiven Kabelanschluss 24 und einen negativen Kabelanschluss 26 auf.

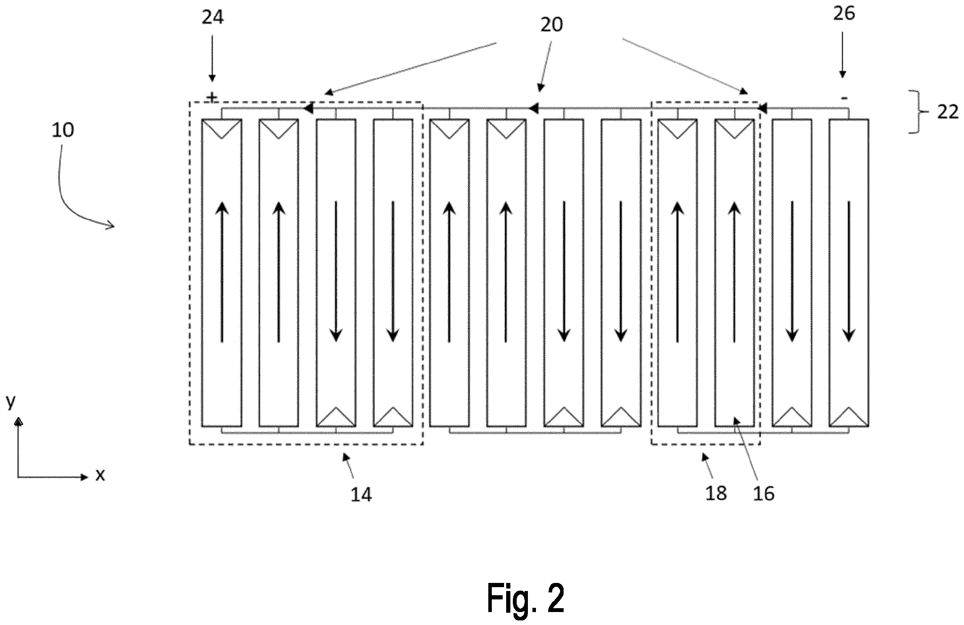

In der Fig. 2 ist eine erstes Ausführungsbeispiel des erfindungsgemäßen PV-Moduls 10 schematisch dargestellt. Das PV-Modul 10 weist mehrere Solar-Strings 14 auf, die in einem Rahmen (in der Fig. 2 nicht abgebildet) eingebaut werden können und die miteinander verbunden sind. Jedes der insgesamt drei Solar-Strings 14 weist in dem hier abgebildeten Ausführungsbeispiel vier Substrings 16 auf, von denen jeweils zwei Substrings 16 zu einem Substring-Paar 18 (im Englischen auch als twin paralleled sub-string bezeichnet) verschaltet sind.

Zudem weist das PV-Modul 10 drei Überbrückungselemente 20 auf, die in diesem Ausführungsbeispiel als Überbrückungsdioden ausgebildet sind. Die Überbrückungselemente 20 sind in einem Randbereich 22 des PV-Moduls 10 angeordnet. Der Randbereich 20 verläuft entlang der Längsachse des PV-Moduls 10. Im Gegensatz zu der ansonsten üblichen Anordnung in der Mitte eines PV-Moduls, werden durch die Anordnung der Überbrückungselemente 20 im Randbereich 22 des PV-Moduls 10 die Abschirmeffekte signifikant reduziert, wodurch die Gesamtleistung des PV-Moduls 10 im Falle einer teilweisen Abschirmung erhöht wird.

Darüber hinaus weist das PV-Modul 10 einen positiven Kabelanschluss 24 und einen negativen Kabelanschluss 26 auf, die jeweils in einem Eckbereich des PV-Moduls 10 angeordnet sind. Anders ausgedrückt weisen die Kabelanschlüsse 24, 26 einen relativ geringen Abstand zu den Ecken des PV-Moduls auf. Insbesondere kann der Abstand der Kabelanschlüsse 24, 26 zu einem der Ecken des PV-Moduls weniger als 20 %, 15 %, 10 % oder 5 % der Breite des PV-Moduls 10 betragen. Auch kann vorgesehen sein, dass der Abstand der Kabelanschlüsse 24, 26 zu den zwei nächstgelegenen Kanten des PV-Moduls maximal 20 %, 15 %, 10 % oder 5 % der Breite des PV-Moduls 10 betragen. Durch die Anordnung der Kabelanschlüsse 24, 26 im Eckbereich des PV-Moduls 10 wird erreicht, dass insgesamt weniger freie Kabel vorhanden sind, wodurch die Abschirmeffekte, die ansonsten durch die Kabel verursacht werden, signifikant reduziert werden.

Bei dem in der Fig. 2 gezeigten Ausführungsbeispiel sind die Solarzellen im Vergleich zum üblichen Halbformat-Design um 90° rotiert und diese sind im Querformat entlang der langen Kante des PV-Moduls 10 angeordnet. Jeder Substring 16 umfasst mehrere Solarzellen, die in Reihe miteinander verschaltet sind. Die Substrings 16 sind wiederum sind parallel mit einem benachbarten Substring 16 verschaltet und bilden gemeinsam mit dem benachbarten Substring 16 ein Substring-Paar 18 (auch als twin sub-string bezeichnet). Jeweils zwei Substring-Paare 18 sind in Reihe zu einem Solar-String 14 verschaltet und gemeinsam über ein Überbrückungselement 20 geschützt. Die Überbrückungselemente 20 schützen die Solarzellen im Falle teilweiser Abschattung der Solarzellen.

Es ist anzumerken, dass die Anzahl der Substrings 16, der Substring-Paare 18 sowie der Solar-Strings 14 in dem vorstehend beschriebenen Ausführungsbeispiel rein beispielhaft zu verstehen ist und dass sich die vorliegende Erfindung nicht auf eine bestimmte Anzahl der genannten Elemente beschränkt. Zudem ist die vorliegende Erfindung unabhängig von der Bifazialität der Solarzellen.

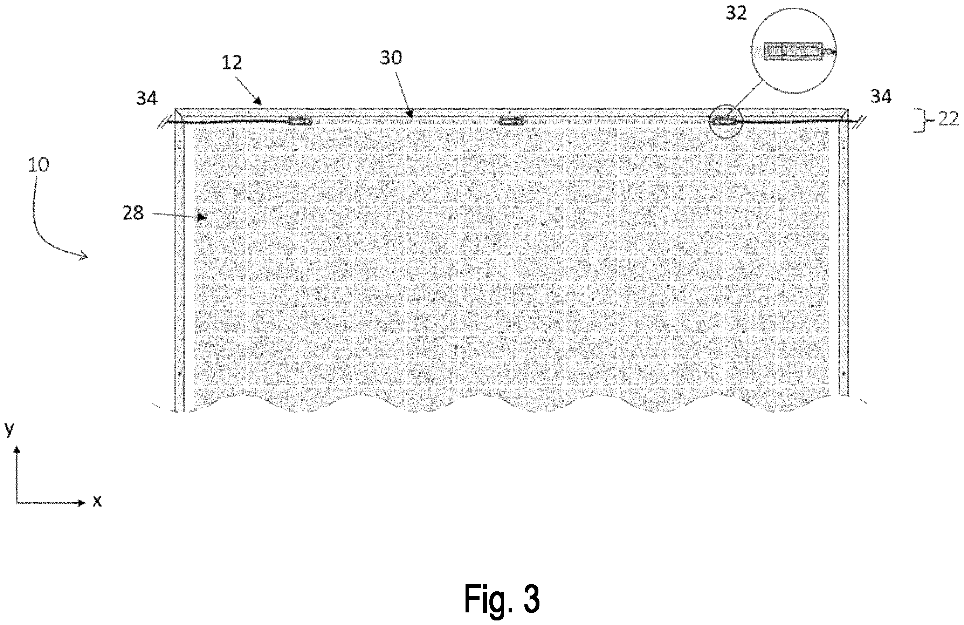

In der Fig. 3 ist ein zweites Ausführungsbeispiel des erfindungsgemäßen PV-Moduls 10 schematisch dargestellt, wobei in dieser Figur die Rückseite des PV-Moduls 10 abgebildet ist. Wie in diesem Ausführungsbeispiel gezeigt ist, umfasst das PV-Modul 10 zahlreiche Solarzellen 28, die innerhalb des Rahmens 12 angeordnet sind. Bei diesem Ausführungsbeispiel sind die Überbrückungselemente jeweils in einer Anschlussbox 32 angeordnet, wobei die Anschlussboxen 32 innerhalb des Rahmens 12, unmittelbar an den Rahmen 12 angrenzend oder unterhalb des Rahmens 12 im Randbereich 22 des PV-Moduls 10 positioniert sein können. Alternativ hierzu können im Rahmen der vorliegenden Erfindung die Anschlussboxen 32, die bevorzugt besonders flach ausgebildet sind, auch auf der Vorderseite des PV-Moduls 10 angeordnet sein. In jedem Fall sind die Anschlussboxen jedoch in einem Randbereich 22 angeordnet, der an eine der langen Kanten des PV-Moduls 10 angrenzt.

Durch die Anordnung der Anschlussboxen 32 innerhalb des Rahmens 12 oder unterhalb des Rahmens werden die Abschattungseffekte, die ansonsten durch die Anschlussboxen 32 verursacht würden, vollständig oder nahezu vollständig vermieden. Dadurch wird eine erhöhte Effizienz des PV-Moduls 10 erreicht. Aber auch wenn die Anschlussboxen 32 auf der Oberseite des PV-Moduls angeordnet sind, werden die Abschattungseffekte dennoch im Vergleich zur mittigen Anordnung gemäß dem Stand der Technik deutlich reduziert.

Die Anschlussboxen 32 sind untereinander mit Querverbindungselementen 30 verbunden. Zudem ist in der Fig. 3 zu erkennen, dass die Anschlussboxen 32 keine Überlappung mit den Solarzellen 28 aufweisen und daher auch keine Abschattung der Solarzellen 28 verursachen. Ferner weist das PV-Modul 10 gemäß der Fig. 3 Anschlusskabel 34 auf, die mit den äußeren Anschlussboxen 32 verbunden sind.

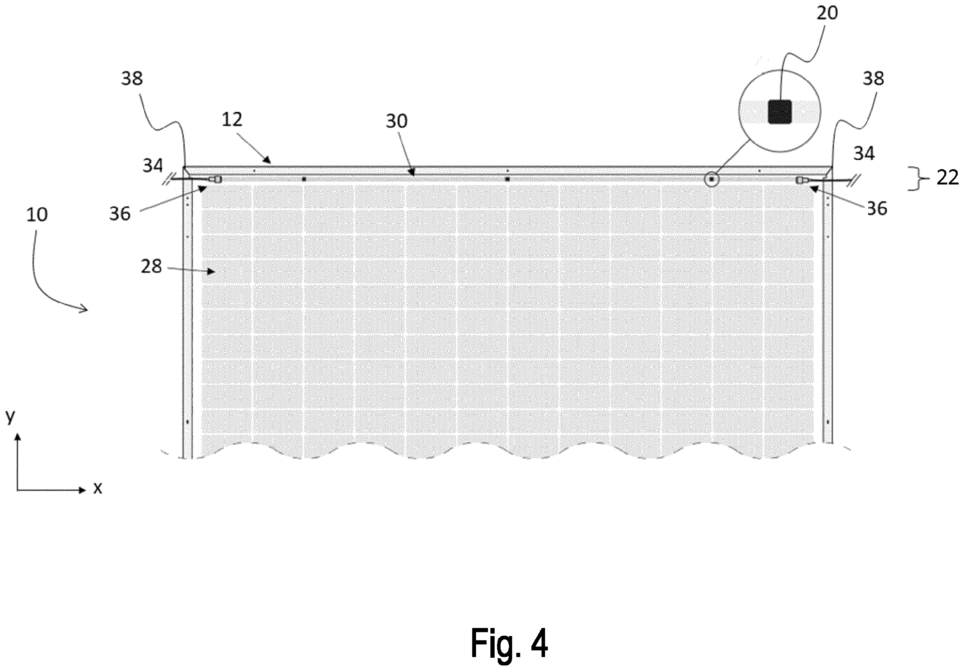

In der Fig. 4 ist ein drittes Ausführungsbeispiel des erfindungsgemäßen PV-Moduls 10 schematisch dargestellt, wobei in dieser Figur ebenfalls die Rückseite des PV-Moduls 10 abgebildet ist. Bei dem in der Fig. 4 gezeigten Ausführungsbeispiel sind die Überbrückungselemente 20 innerhalb eines Laminats eingebettet, und zwar (wie bereits bei den zuvor beschriebenen Ausführungsbeispielen) im Randbereich 22 des PV-Moduls 10. Im Vergleich zu dem in der Fig. 3 gezeigten Ausführungsbeispiel weist das in der Fig. 4 dargestellte PV-Modul 10 Anschlussklemmen 36 auf, die in der Nähe der Eckpunkte 38 angeordnet sind. Die Anschlusskabel 34 führen von den Anschlussklemmen 36 heraus. Der Abstand zwischen den Anschlussklemmen 36 zu den beiden jeweils nächstliegenden Kanten des rechteckigen PV-Moduls beträgt bevorzugt weniger als 20 %, 15 %, 10 % oder 5 % der Breite des PV-Moduls 10. Das in der Fig. 4 gezeigte Design erlaubt eine Reduzierung der Überlappung der Anschlusskabel 34 mit den Solarzellen 28, wodurch die Abschattungseffekte signifikant reduziert werden und folglich die Effizienz des PV-Moduls 10 erhöht wird. Zudem führt das in der Fig. 4 gezeigte Design zu einem im Vergleich zu den aus dem Stand der Technik gekannten Designs geringeren Bedarf an Kabeln.

Die PV-Module gemäß der vorliegenden Erfindung können insbesondere im Bereich der Agrar-Voltaik, an Zäunen und an Lärmschutzwänden verwendet werden, sind aber nicht auf die Anwendung in den vorstehend genannten Gebieten begrenzt. Erste Untersuchungen haben gezeigt, dass die erfindungsgemäßen PV-Module besonders gut für die vertikale Installation geeignet sind. Ihre Anwendung ist jedoch nicht auf derartige Installationen beschränkt.

### BEZUGSZEICHENLISTE

- 10: Photovoltaik-Modul
- 12: Rahmen
- 14: Solar-Strings
- 16: Substrings
- 18: Substring-Paar
- 20: Überbrückungselement
- 22: Randbereich
- 24: positiver Kabelanschluss
- 26: negativer Kabelanschluss
- 28: Solarzelle
- 30: Querverbindungselement
- 32: Anschlussbox
- 34: Anschlusskabel
- 36: Anschlussklemme
- 38: Eckpunkt
- x: Längsachse des Photovoltaik-Moduls
- y: Querachse des Photovoltaik-Moduls

## Patentansprüche

1. Photovoltaik-Modul (10), umfassend:
- einen Rahmen (12),
- mehrere innerhalb des Rahmens (12) aufgenommene Solar-Strings (14), wobei jeder Solar-String (14) mehrere Solarzellen (28) aufweist, die seriell miteinander verbunden sind, und die Solar-Strings (14) untereinander verbunden sind; und
- mindestens zwei Überbrückungselemente (20), wobei die mindestens zwei Überbrückungselemente (20) in einem Randbereich (22) des Photovoltaik-Moduls (10) angeordnet sind, der parallel zu der Längsachse des Photovoltaik-Moduls (10) verläuft.

2. Photovoltaik-Modul (10) nach Anspruch 1, **dadurch gekennzeichnet, dass** das Photovoltaik-Modul (10) als bifaziales Photovoltaik-Modul ausgebildet ist.

3. Photovoltaik-Modul (10) nach Anspruch 1 oder 2, **dadurch gekennzeichnet, dass** mindestens ein Überbrückungselement (20) als Überbrückungsdiode ausgestaltet ist.

4. Photovoltaik-Modul (10) nach einem der Ansprüche 1 bis 3, **dadurch gekennzeichnet, dass** die Überbrückungselemente (20) zwischen dem Rahmen (12) und den Solarzellen (28) angeordnet sind.

5. Photovoltaik-Modul (10) nach einem der Ansprüche 1 bis 4, **dadurch gekennzeichnet, dass** die Überbrückungselemente (20) in einem Laminat eingebettet sind.

6. Photovoltaik-Modul (10) nach einem der Ansprüche 1 bis 4, **dadurch gekennzeichnet, dass** die Überbrückungselemente (20) jeweils in einer Anschlussbox (32) angeordnet sind.

7. Photovoltaik-Modul (10) nach Anspruch 6, **dadurch gekennzeichnet, dass** die Anschlussbox (32) eine flache Form aufweist.

8. Photovoltaik-Modul (10) nach einem der Ansprüche 1 bis 7, **dadurch gekennzeichnet, dass** die Solar-Strings (14) eine Längsausrichtung aufweisen und diese Längsausrichtung orthogonal zu der Längsachse des Photovoltaik-Moduls (10) verläuft.

9. Photovoltaik-Modul (10) nach einem der Ansprüche 1 bis 8, **dadurch gekennzeichnet, dass**
- mehrere Solarzellen (28) seriell zu einem Substring (16) verschaltet sind;
- mindestens zwei Substrings (16) parallel zueinander verschaltet sind;
- jeweils mindestens zwei parallele Substrings (16) seriell zu einem Solar-String (14) verschaltet sind; und
- jeweils ein Solar-String (14) mit einem Überbrückungselement (20) verbunden ist.

10. Photovoltaik-Modul (10) nach einem der Ansprüche 1 bis 9, ferner **gekennzeichnet durch** Kabelanschlüsse (24, 26), die in einem Eckbereich des Photovoltaik-Moduls (10) angeordnet sind.
